## Europäisches Patentamt
## European Patent Office
## Office européen des brevets

(19)

(11) Numéro de publication: **0 159 258**
**B1**

(12) # FASCICULE DE BREVET EUROPÉEN

(45) Date de publication du fascicule du brevet:
27.12.89

(51) Int. Cl.⁴: **H 01 L 33/00,** G 02 B 6/26,
H 01 S 3/06

(21) Numéro de dépôt: 85400626.9

(22) Date de dépôt: 29.03.85

(54) Procédé de fabrication d'un dispositif optique intégré monolithique comprenant un laser à semiconducteur et dispositif obtenu par ce procédé.

(30) Priorité: 30.03.84 FR 8405053

(43) Date de publication de la demande:
23.10.85 Bulletin 85/43

(45) Mention de la délivrance du brevet:
27.12.89 Bulletin 89/52

(84) Etats contractants désignés:
DE GB IT NL

(56) Documents cité:
GB-A-1 539 028
GB-A-2 124 024
US-A-4 114 257

XEROX DISCLOSURE JOURNAL, vol. 4, no. 3,
mai/juin 1979, pages 355-356, Stamford,
Connecticut, US; R.D. BURNHAM et al.:
"Compositional coupling of lasers into low loss
waveguides"
PATENTS ABSTRACTS OF JAPAN, vol. 8, no. 206 (E-
267) 1643, 20 septembre 1984; & JP - A - 59 90 981
(NIPPON DENKI K.K.) 25-05-1984

(73) Titulaire: **Menigaux, Louis, 85 avenue des Tilleuls,
F-91440 Bures sur Yvette (FR)**
Titulaire: **Carenco, Alain, 68 Ter, avenue Foch,
F-92260 Fontenay- aux- Roses (FR)**
Titulaire: **Sansonetti, Pierre, 13, rue Baillou, F-75014
Paris (FR)**

(72) Inventeur: **Menigaux, Louis, 85, Avenue des
Tilleuls, F-91440 Bures- sur- Yvette (FR)**
Inventeur: **Carenco, Alain, 68, Avenue Foch,
F-92260 Fontenay- aux- Roses (FR)**
Inventeur: **Sansonetti, Pierre, 13, rue Baillou,
F-75014 Paris (FR)**

(74) Mandataire: **Mongrédien, André, c/o BREVATOME
25, rue de Ponthieu, F-75008 Paris (FR)**

EP 0 159 258 B1

## Description

La présente invention a pour objet un procédé de réalisation d'un "circuit optique", ce terme désignant de manière générale un dispositif comprenant des couches semi conductrices aptes à créer un milieu amplificateur, un moyen pour créer un résonateur optique, un moyen pour extraire du milieu amplificateur le rayonnement optique stimulé et le guider vers l'extérieur et divers autres composants tels que des photodétecteurs ou des modulateurs électro-optiques. De tels dispositifs trouvent une application en télécommunications optiques.

L'invention vise à obtenir un tel circuit dans une version intégrée monolithique, c'est-à-dire qui fait appel à une technologie commune de réalisation des divers éléments et non à une technique d'assemblage de divers composants réalisés séparément.

L'une des difficultés posées par l'intégration monolithique d'un laser à semiconducteur, est la réalisation du résonateur, lequel permet, combiné à la couche active formant le milieu amplificateur, l'obtention d'un rayonnement lumineux cohérent. Plusieurs solutions ont été retenues dans l'art antérieur : réalisation de deux miroirs par usinage chimique ou ionique ; emploi de structures périodiques du genre réseaux de diffraction, disposées à l'extérieur de la couche active ou réparties dans celle-ci.

Un autre problème posé par l'intégration monolithique est la nécessité de pouvoir disposer d'une couche transparente apte à servir de guide optique au rayonnement émis par la couche active. Le couplage entre cette couche active et le guide optique conduit à une redéfinition de la structure du laser.

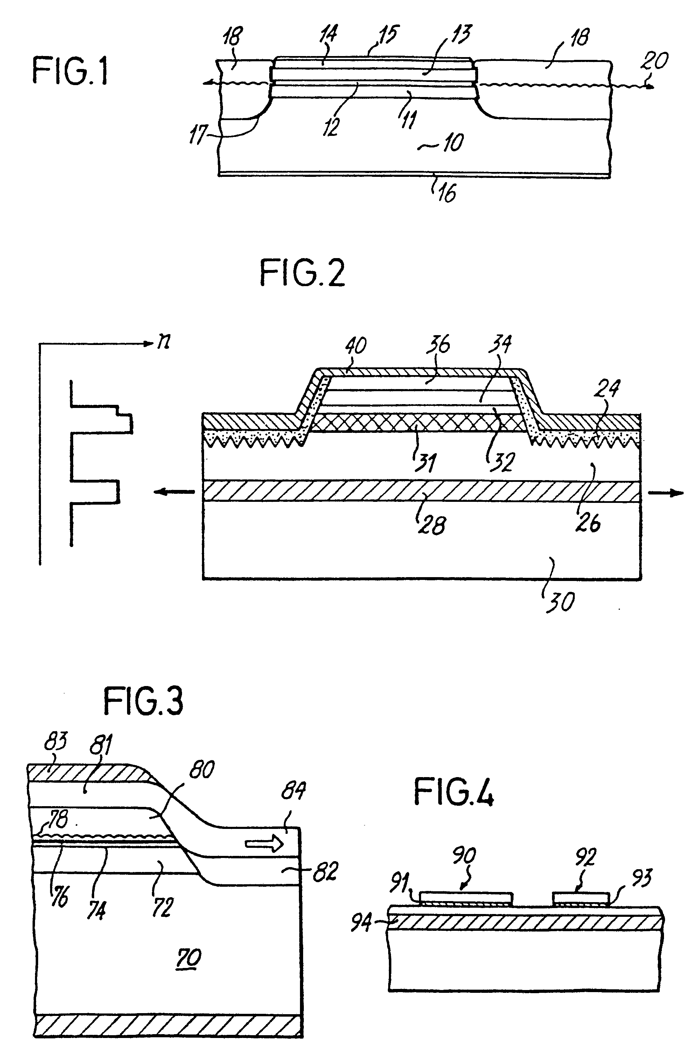

Les figures 1 à 4 annexées permettent de mieux préciser ces questions. Elles décrivent quelques structures connues qui apportent différentes solutions à ces problèmes.

Le laser représenté sur la figure 1 comprend un substrat 10, une première couche de confinement 11, une couche active 12, une seconde couche de confinement 13, une couche de contact 14, une couche métallique 15 formant premier contact ohmique et une couche métallique 16, disposée sous le substrat, et formant second contact ohmique. Une couche isolante et transparente 17 recouvre les bords de la structure. Un guide d'onde optique 18 est déposé de chaque côté du laser. La composition et l'épaisseur des principales couches peuvent être par exemple les suivantes :

| 15 : | Cr-Au | |
|------|-------|--------|
| 14 : | $p^+GaAs$ | 1μm |
| 13 : | $p^+Al_{0,3}Ga_{0,7}As$ | 2μm |
| 12 : | $p^+GaAs$-Si | 1μm |
| 11 : | $n^+Al_{0,3}Ga_{0,7}As$ | 2,5μm |
| 10 : | $n^+GaAs$ | |
| 16 : | Au-Sn | |
| 17 : | $SiO_2$ | |
| 18 : | n⁻GaAs | 12μm |

Cette structure connue est décrite dans l'article de C. E. HURWITZ et al intitulé "Integrated GaAs-AlGaAs Double-heterostructure Lasers" publié dans Applied Physics Letters, Vol. 27, N° 4, 15 août 1975, pages 241, 243.

La structure représentée sur la figure 2, comprend elle aussi, un guide d'onde optique couplé à la couche active, mais dans une disposition différente qui est celle des laser dits "Integrated Lwin-Guide-Lasers with Distributed Bragg Reflector" ou en abrégé "DBR-ITG Lasers".

Tel que représenté le laser comprend un substrat 30 en InP de type n, une couche 28 en $Ga_{u-v}In_{1-}As_vP_{1-v}$ (u et v < 1), une couche de confinement 26 en InP de type n, une couche active 31 en $Ga_xIn_{1-x}As_yP_{1-y}$ (x et y < 1), une couche 32 en GaInAsP de type p, une couche 34 en InP de type p, une couche de contact 36 en GaInAsP, enfin une couche d'or 40. Le réseau de diffraction est constitué sur la couche de séparation 26. La couche de $SiO_2$ 24 assure l'isolement électrique.

Une telle structure est décrite notamment dans l'article de K. UTAKA et al intitulé "1.5 - 1.6 μm GaInAsP/InP Integrated Twin-Guide lasers with First Order Distributed Bragg Reflectors" publié dans Electronics Letters" 5 juin 1980, vol. 16, N° 12.

L'indice de réfraction des couches est représenté sur la partie gauche de la figure. On observera que l'indice de la couche 28 est supérieur aux indices des couches adjacentes 26 et 30, ce qui est propice au guidage du rayonnement dans la couche 28.

Comme il est également connu, le réseau de diffraction du laser peut être réparti tout au long du milieu amplificateur au lieu d'être placé à chacune des extrémités. On obtient alors un laser dit DFB pour "Distributed Feedback".

Un tel dispositif est représenté sur la figure 3. Il comprend un substrat 70 en GaAs, de type n, une couche 72 en $Ga_{0,7}Al_{0,3}As$, de type n, une couche active 74 en GaAs de type p, une couche 76 en $Ga_{0,8}Al_{0,2}As$ de type p surmontée d'une couche 78 en $Ga_{0,93}Al_{0,07}As$ de type p où est formé le réseau distribué, une couche 80 en $Ga_{0,7}Al_{0,3}As$ de type p, une couche 81 en $Ga_{0,9}Al_{0,1}As$ dopée de type p par diffusion de Zn au-dessus de la couche active et une couche conductrice 83. La sortie du rayonnement s'effectue par un guide d'onde comprenant une couche 82 en $Ga_{0,7}Al_{0,3}As$ de type p surmontée d'une couche 84 en $Ga_{0,9}Al_{0,1}As$, non dopée en dehors de la couche active du laser.

Une telle structure est décrite par K. AIKI et al dans un article intitulé "A Frequency Multiplexing Light Source with Monolithically Integrated Distributed-feedback Diode Lasers" publié dans IEEE Journal of Quantum Electronics, vol. QE-13, N°4, Avril 1977, pages 220 - 223.

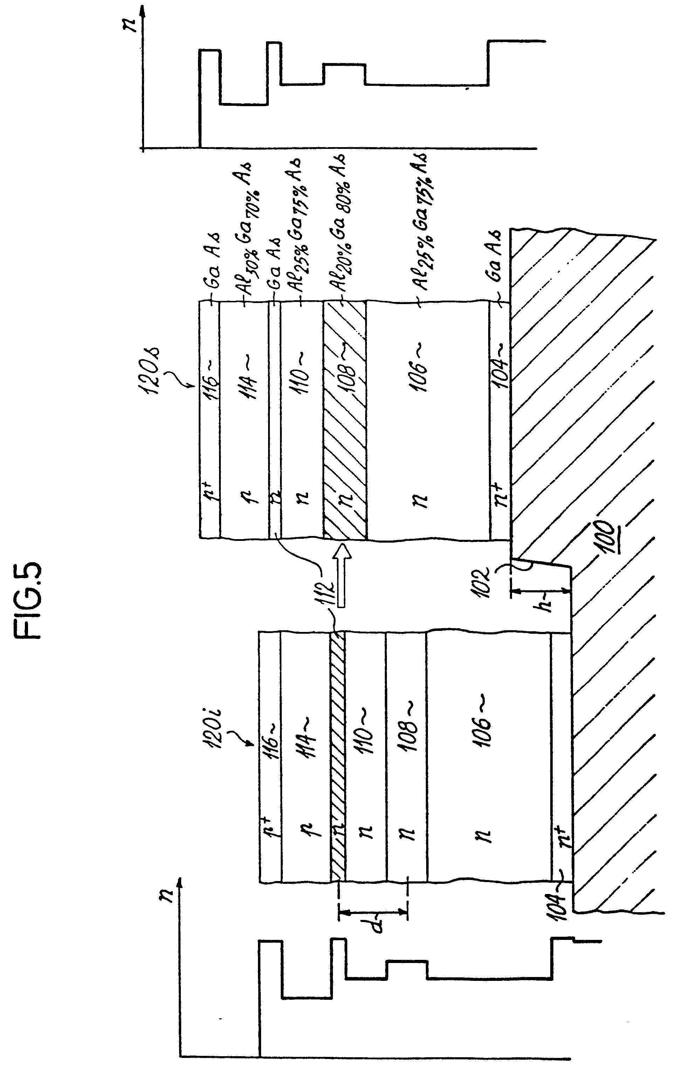

La figure 4, enfin, montre un dispositif optique intégré comprenant un laser 90 et un photodétecteur 92, chacun de ces éléments comprenant essentiellement une couche active identique, respectivement 91 et 93. Ces couches sont couplées optiquement à un guide optique 94, selon les principes exposés plus haut. Une telle structure est décrite dans l'article de J. L. MERZ et al intitulé "GaAs Integrated Optical Circuits by Wet Chemical Etching" publié dans IEEE Journal of Quantum Electronics, vol. QE-15, N°2, Février 1979, pages 72 - 82.

Toutes ces techniques présentent des inconvénients, soit qu'elles conduisent à un couplage médiocre entre la couche active et le guide optique (variantes des figures 2 et 4), soit qu'elles nécessitent plusieurs opérations d'épitaxies (variantes des figures 1 et 3).

Par ailleurs, on connaît, par le document GB-A-2 124 024, un procédé de réalisation de dispositifs optiques par empilement de couches semiconductrices par épitaxie sur un substrat ayant un profil en forme de marche permettant de mettre à la même hauteur une couche active et une couche de guidage. L'ordre des couches déposées est tel que l'empilement supérieur est l'empilement laser, lequel se trouve donc situé au-dessus de la structure de l'ensemble.

La présente invention a justement pour but de remédier à ces inconvénients. A cette fin, elle propose un procédé de fabrication qui ne requiert qu'une seule opération d'épitaxie et qui conduit à un excellent couplage entre la couche active et la couche servant de guide optique.

Par ailleurs, le procédé de l'invention permet d'obtenir une structure plane et utilise les propriétés de l'épitaxie en phase vapeur.

De façon précise, la présente invention a pour objet un procédé de fabrication d'un dispositif optique intégré monolithique à structure planaire comprenant au moins un laser à semiconducteur et un guide d'onde optique par empilement de couches semiconductrices par épitaxie sur un substrat, ce procédé comportant les opérations suivantes :

- on donne au substrat un profil présentant au moins une marche de hauteur (h) entre deux niveaux de hauteurs différentes, un niveau inférieur et un niveau supérieur,
- on dépose sur ce substrat, par une seule opération d'épitaxie réalisée en phase vapeur, successivement une première couche de confinement, une couche de guidage en un matériau transparent pour le rayonnement émis par le laser, une deuxième couche de confinement, une couche active, une troisième couche de confinement, une couche de contact,
- on choisit le matériau transparent pour que son indice de réfraction soit supérieur aux indices des couches de confinement qui l'encadrent,
- on donne aux épaisseurs de la couche transparente, de la deuxième couche de confinement et de la couche active des valeurs telles que la distance (d) séparant les plans médians de la couche active et de la couche transparente soit égale à la hauteur (h) de la marche du substrat, la couche active de l'empilement inférieur déposé sur le niveau inférieur du substrat se trouvant alors au même niveau que la couche transparente de l'empilement supérieur déposé sur le niveau supérieur du substrat, l'empilement inférieur constituant un laser émettant un rayonnement dans le plan de la couche active, ce rayonnement pénétrant dans et étant guidé par la couche transparente de l'empilement supérieur servant de guide optique.
- on décape les couches supérieures de l'empilement supérieur pour mettre à niveau les deux empilements inférieur et supérieur.

Ce procédé peut présenter diverses variantes selon le type de résonateur utilisé (miroirs usinés, réseaux de diffraction extérieurs à la couche active) ou selon la structure finale à obtenir (laser associé à un photodétecteur, etc...), selon les considérations développées plus haut à propos de l'art antérieur.

La présente invention a également pour objet un dispositif obtenu par le procédé qui vient d'être défini, ce dispositif comprenant :

- un substrat ayant un profil présentant au moins une marche de hauteur (h) entre deux niveaux de hauteurs différentes, un niveau inférieur et un niveau supérieur,
- sur ce substrat successivement une première couche de confinement, une couche de guidage en un matériau transparent pour le rayonnement émis par le laser, une deuxième couche de confinement, une couche active, une troisième couche de confinement, une couche de contact,
- le matériau transparent ayant un indice de réfraction supérieur aux indices des couches de confinement qui l'encadrent,
- les épaisseurs de la couche transparente, de la deuxième couche de confinement et de la couche active ayant des valeurs telles que la distance (d) séparant les plans médians de la couche active et de la couche transparente soit égale à la hauteur (h) de la marche du substrat, la couche active de l'empilement inférieur déposé sur le niveau inférieur du substrat se trouvant alors au même niveau que la couche transparente de l'empilement supérieur déposé sur le niveau supérieur du substrat,
- l'empilement inférieur de ce dispositif constituant un laser émettant un rayonnement dans le plan de la couche active, ce rayonnement pénétrant dans et étant guidé par la couche transparente de l'empilement supérieur servant de guide optique.
- les couches supérieures de l'empilement supérieur étant décapées, les deux empilements inférieur et supérieur arrivant alors au même niveau.

De toute façon, les caractéristiques et avantages de l'invention apparaîtront mieux après la description qui suit, d'exemples de réalisation donnés à titre explicatif et nullement limitatif. Cette description se réfère à des dessins annexés sur lesquels :

- la figure 1, déjà décrite, représente schématiquement un laser à faces usinées avec un guide optique de sortie,
- la figure 2, déjà décrite, représente un laser à réseaux de diffraction situés à l'extérieur de la couche active, au-dessus d'un guide optique de couplage,
- la figure 3, déjà décrite, représente un laser à réaction distribuée et à guide de sortie,
- la figure 4, déjà décrite, illustre un dispositif intégré à laser et à photodétecteur, couplés par un guide d'onde,
- la figure 5 montre, en coupe, une structure générale illustrant le procédé de l'invention,
- la figure 6 montre un mode particulier de mise en oeuvre du procédé de l'invention, dans le cas d'une structure dont les réflecteurs sont des réseaux,
- la figure 7 illustre un autre mode de mise en oeuvre dans le cas d'une structure à laser et à photodétecteur ou modulateur électro-optique.

L'idée de base de l'invention est d'utiliser le double fait suivant :

- la croissance par épitaxie en phase vapeur (organométallique ou par jet moléculaire) sur un substrat, suit rigoureusement, dans le cas général, le profit du substrat,
- la zone de transition entre deux niveaux de hauteurs différentes n'est pratiquement pas perturbée dans sa composition.

Ces propriétés de l'épitaxie en phase vapeur sont utilisées dans l'invention pour provoquer un décalage dans l'ordre des couches déposées sur les deux marches du substrat et pour permettre l'injection directe de la lumière d'une des couches dans une autre.

Pour cela, la hauteur de la marche doit être choisie de façon à ce que la zone active du laser se trouve en face d'une couche transparente. Par ailleurs, pour que cette dernière soit guidante, il suffit qu'elle soit environnée de deux couches de plus faible indice. Si la couche en question est, par exemple, en $Al_xGa_{1-x}As$, les couches adjacentes seront en $Al_yGa_{1-y}As$ avec y > x.

Les épaisseurs et les compositions des couches sont choisies en fonction des propriétés recherchées pour le circuit. On évitera en particulier qu'il ait transfert de lumière par onde évanescente de la couche active vers des couches adjacentes (effet utilisé dans les coupleurs directifs).

La figure 5 illustre le procédé de l'invention dans sa conception générale.

Sur un substrat 100 semi-isolant orienté (001), par exemple en GaAs, on réalise par usinage chimique ou ionique une marche 102 de hauteur h (par exemple 1,5 µm). Cette marche est parallèle à l'un des plans de clivage (par exemple parallèle à la direction (110). Des couches semiconductrices sont ensuite déposées par épitaxie en phase vapeur : une première couche conductrice 104 en GaAs de type $n_+$, de 0,5 µm d'épaisseur, qui sert de contact commun au circuit et qui est nécessaire du fait que le substrat est semiisolant ; une couche 106 en $Al_{0,25}Ga_{0,75}As$ de type n de 3 µm, qui sert de confinement optique pour le guide ; une couche 108 de $Al_{0,20}Ga_{0,80}As$ de type n de 1 µm, qui sert de guide ; une couche 110 de $Al_{0,25}Ga_{0,75}As$ de type n de 1 µm, qui sert de confinement optique à la fois pour la couche précédente et pour la couche suivante ; une couche 112 en GaAs d'épaisseur 0,2 µm, qui sert de couche active au laser ; une couche 114 en $Al_{0,30}Ga_{0,70}As$ de 1,3 µm de type p, qui sert au confinement pour la couche active ; et enfin une couche de contact 116 en GaAs de type p de 0,5 µm.

On obtient ainsi deux empilements de couches semi conductrices : un empilement inférieur 120i déposé sur le niveau inférieur du substrat (partie gauche de la figure 5) et un empilement supérieur 120s déposé sur le niveau supérieur du substrat (partie droite). Ces deux empilements sont de compositions identiques mais les niveaux des différentes couches sont décalés d'une hauteur h.

Les couches 108, 110 et 112 ont une épaisseur telle que la distance d entre les plans médians des couches 108 et 112 est égale à la hauteur h de la marche 102. Ainsi, la couche 112 de l'empilement inférieur 120i de la partie gauche est-elle en regard de la couche 108 de l'empilement supérieur 120s de la partie droite.

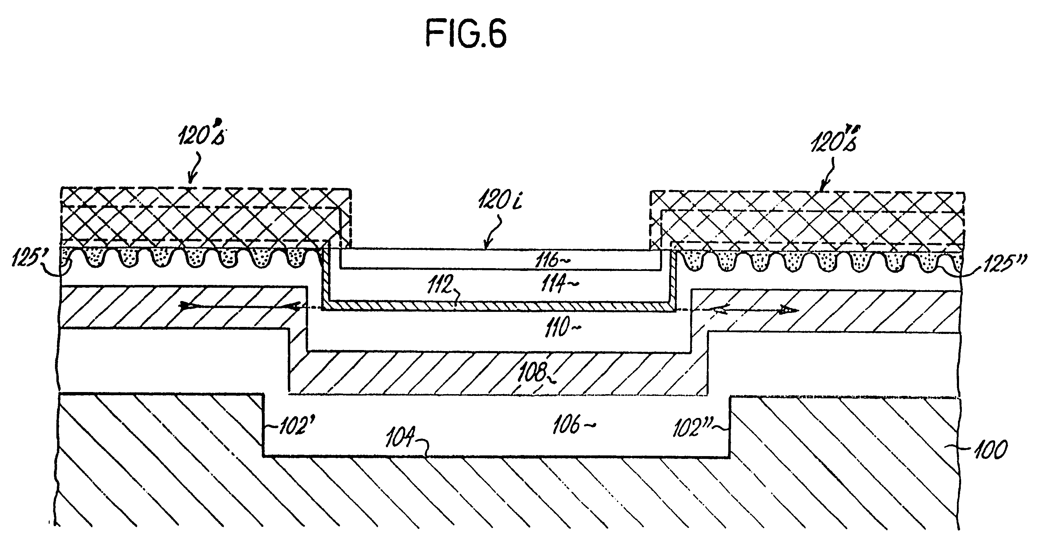

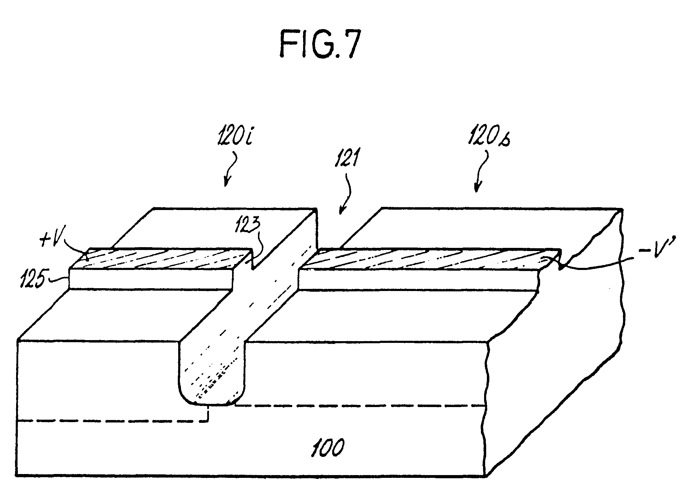

Sur la figure 5, la partie qui s'intercale entre les deux empilements 120i et 120s n'est pas représentée explicitement, car elle dépend de la structure finale souhaitée. Sur la figure 6, on verra un cas où les couches sont continues et se rejoignent mutuellement par une zone fortement inclinée épousant la forme de la marche du substrat. Sur la figure 7 on verra un autre exemple où les deux empilements sont séparés par un canal.

Pour en revenir à la figure 5, il est clair que, selon le présente invention, les couches 112, 114 et 116 de l'empilement supérieur 120s n'ayant aucune utilité, sont supprimées par décapage. Le dispositif présente alors une face supérieure plane, les épaisseurs des couches 114 et 116 étant convenablement choisies.

Il convient également de traiter l'ensemble et surtout l'empilement inférieur 120i, par les opérations habituelles propres à la réalisation des lasers à semiconducteurs : par exemple bombardement protonique pour délimiter un ruban actif et dépôt d'une couche métallique formant contact ohmique sur la couche 116.

Sur les parties gauche et droite de la figure 5 sont représentées en outre les variations de l'indice de réfraction des différentes couches. On observera que la couche 108, qui sert de guide dans la partie droite de la structure, a son indice supérieur à celui des couches voisines 106 et 110.

La figure 6 représente une variante de mise en oeuvre dans laquelle le substrat 100 présente deux marches 102' et 102", donc deux niveaux supérieurs 120' s et 120"s encadrant un niveau inférieur 120i. Selon ce mode de mise en oeuvre, la couche 110 est l'objet d'un traitement approprié apte à conférer à ses propriétés de guidage une modulation périodique (125', 125") permettant de former des réflecteurs de Bragg. La structure obtenue est donc finalement un laser de type DBR avec une partie centrale émissive (couche active 112) et deux parties réfléchissantes (120' s, 120"s) formant résonateur.

Les interfaces abruptes induites par la marche entre l'empilement central 120i et les deux empilements supérieurs 120's et 120"s permettent d'obtenir le transfert direct de la lumière de la couche active 112 vers les deux guides, sans avoir à usiner de miroirs entre la partie centrale 120i et les parties extrêmes 120's et 120"s.

Naturellement, on peut aussi, avec le procédé de l'invention, obtenir une structure à contre-réaction distribuée (laser DBR) selon les principes exposés plus haut à propos de la figure 3.

Enfin, la figure 7 représente une variante dans laquelle la partie intermédiaire entre les deux empilements est usinée par les techniques habituelles de gravure de façon à créer un canal 121. Ceci fait apparaître un miroir 123, un autre miroir 125 étant obtenu par clivage. On obtient ainsi un laser à deux miroirs, l'un usiné et l'autre clivé, ce laser émettant dans un guide de lumière extérieur.

Avec le dispositif de la figure 7, il est possible, si besoin est d'agir par effet électro-optique sur la lumière sortant du guide en polarisant en inverse une diode Schottky, ou une jonction p-n (à condition d'avoir conservé, au cours de la remise à niveau des deux parties du dispositif tout ou partie de la couche épitaxiée de type p).

Après cette description, on a compris que l'intérêt majeur du procédé de l'invention tient dans la possibilité d'opérer en une seule opération d'épitaxies. Pour obtenir des dispositifs semblables à ceux qui ont été décrits, on pourrait toujours procéder en plusieurs étapes, par exemple en déposant d'abord, sur un côté d'un substrat une structure de guidage, puis en déposant sur l'autre côté une structure d'amplification, (ce qui d'ailleurs soulève une difficulté majeure dans l'alignement des deux sous-ensembles), puis enfin, en formant des couches recouvrant l'ensemble et en assurant le confinement latéral. Mais une telle procédure demanderait trois opérations d'épitaxies. Dans l'invention, une seule opération d'épitaxies est nécessaire, l'alignement entre la couche active et le guide étant obtenu automatiquement.

**Revendications**

1. Procédé de fabrication d'un dispositif optique intégré monolithique à structure planaire, comprenant au moins un laser à semiconducteur et un guide d'onde optique, par empilement de couches semiconductrices par épitaxie sur un substrat, ce procédé comportant les opérations suivantes :

– on donne au substrat (100) un profil présentant au moins une marche (102) de hauteur (h) entre deux niveaux de hauteurs différentes, un niveau inférieur et un niveau supérieur,

– on dépose sur ce substrat, par une seule opération d'épitaxie réalisée en phase vapeur, successivement une première couche de confinement (106), une couche de guidage (108) en un matériau transparent pour le rayonnement émis par le laser, une deuxième couche de confinement (110), une couche active (112), une troisième couche de confinement (114), une couche de contact (116),

– on choisit le matériau transparent (108) pour que son indice de réfraction soit supérieur aux indices des couches de confinement (106, 110) qui l'encadrent,

– on donne aux épaisseurs de la couche transparente (108) de la deuxième couche de confinement (110) et de la couche active (112) des valeurs telles que la distance (d) séparant les plans médians de la couche active (112) et de la couche transparente (108) soit égale à la hauteur (h) de la marche (102) du substrat, le plan médian de la couche active (112) de l'empilement inférieur (120i) déposée sur le niveau inférieur du substrat se trouvant alors au même niveau que le plan médian de la couche transparente (108) de l'empilement supérieur (120s) déposé sur le niveau supérieur du substrat, l'empilement inférieur (120i) constituant un laser émettant un rayonnement dans le plan de la couche active, ce rayonnement pénétrant dans et étant guidé par la couche transparente de l'empilement supérieur (120s) servant de guide optique,

– on décape les couches supérieures (114, 116) de l'empilement supérieur (120s) pour mettre à niveau les deux empilements inférieur et supérieur (120i, 120s).

2. Procédé selon la revendication 1, caractérisé par le fait qu'avant de déposer la première couche de confinement (106), on dépose sur le substrat, s'il est semi-isolant, une couche conductrice de contact (104).

3. Procédé selon la revendication 1, caractérisé par le fait que l'on donne à la deuxième couche de confinement (110) située sur la couche transparente (108) de l'empilement supérieur (120s) une structure en réseau de diffraction distribué.

4. Dispositif optique intégré monolithique à structure planaire, obtenu par le procédé selon la revendication 1, ce dispositif comprenant un laser à semi conducteur et un guide d'onde optique formés d'empilements de couches épitaxiées sur un substrat, ce dispositif comportant :

– un substrat (100) ayant un profil présentant au moins une marche (102) de hauteur (h) entre deux niveaux de hauteurs différentes, un niveau inférieur et un niveau supérieur,

– sur ce substrat successivement une première couche de confinement (106), une couche de guidage (108) en un matériau transparent pour le rayonnement émis par le laser, une deuxième couche de confinement (110), une couche active (112), une troisième couche de confinement (114), une couche de contact (116),

– le matériau transparent (108) ayant un indice de réfraction supérieur aux indices des couches de confinement (106, 110) qui l'encadrent,

– les épaisseurs de la couche transparente (108) de la deuxième couche de confinement (110) et de la couche active (112) ayant des valeurs telles que la distance (d) séparant les plans médians de la couche active (112) et de la couche transparente (108) soit égale à la hauteur (h) de la marche (102) du substrat (100), le plan médian de la couche active (112) de l'empilement inférieur (120i) déposé sur le niveau inférieur du substrat (100) se trouvant alors au même niveau que le plan médian de la couche transparente (108) de l'empilement supérieur (120s) déposé sur le niveau supérieur du substrat,

– l'empilement inférieur (120i) de ce dispositif constituant un laser émettant un rayonnement dans le plan de la couche active (112), ce rayonnement pénétrant dans et étant guidé par la couche transparente (108) de l'empilement supérieur (120s) servant de guide optique,

– les couches supérieures (114, 116) de l'empilement supérieur (120s) étant décapées, les deux empilements inférieur (120i) et supérieur (120s) arrivant alors au même niveau.

5. Dispositif selon la revendication 5, caractérisé par le fait qu'il comprend, entre la première couche de confinement (106) et le substrat (100), une couche conductrice de contact (104), si le substrat est semi-isolant.

6. Dispositif selon la revendication 4, caractérisé par le fait qu'il comprend un empilement inférieur (120i) prolongé par deux empilements supérieurs (120's, 120"s), le rayonnement émis par la couche active (112) de l'empilement inférieur (120i) pénétrant dans et étant guidé par les couches transparentes (108) des deux empilements supérieurs (120's, 120"s), la deuxième couche de confinement (110) située sur la couche transparente (108) des empilements supérieurs (120's, 120"s) ayant une structure de réseau de diffraction distribué (125', 125").

7. Dispositif selon la revendication 4, caractérisé par le fait que l'empilement inférieur (120i) constituant le laser est séparé de l'empilement supérieur (120s) par un sillon gravé (121).

8. Dispositif selon la revendication 7, caractérisé par le fait que l'empilement supérieur (120s) est agencé pour remplir une fonction électrooptique, notamment une photodétection ou une modulation.

**Patentansprüche**

1. Verfahren zur Herstellung einer fugenlosen, aus einem Stück bestehenden, optischen Vorrichtung von plattenartigem Aufbau, die auf einer Unterlage durch Stapeln von durch Epitaxie gebildeten halbleitenden Schichten ausgebildet wird, mit wenigstens einem Halbleiter-Laser und einem optischen Wellenleiter durch die folgenden Arbeitsschritte:

– man gibt der Unterlage (100) ein Profil, das wenigstens einen Höhenverlauf (h, 102) zwischen zwei unterschiedlichen Höhenniveaus, nämlich einem unteren und einem oberen Niveau zeigt,

– man schlägt auf dieser Unterlage in einem einzigen Arbeitsgang einer in einer Dampfphase realisierten Epitaxie nacheinander eine erste Sperrschicht (106), eine Leiterschicht (108) aus einem für die von dem Laser emittierte Strahlung durchlässigen Material, eine zweite Sperrschicht (110), eine aktive Schicht (112), eine dritte Sperrschicht (114) und eine Kontaktschicht (116) nieder,

– man wählt das durchlässige Material (108) derart, daß sein Brechungsindex höher als die Brechungsindizes der Sperrschichten (106, 110) sei, in die das Material eingefügt ist,

– man gibt der Dicke der durchlässigen Schicht (108), der zweiten Sperrschicht (110) und der aktiven Schicht (112) solche Werte, daß der Abstand (d), der die Mittelebenen der aktiven Schicht (112) und der durchlässigen Schicht (108) trennt, gleich der Höhe (h) des Verlaufes (102) der Unterlage sei, wobei die Mittelebene der aktiven Schicht (112) des niedrigeren Stapels (120i), der auf dem tieferen Niveau der Unterlage niedergeschlagen ist, sich dann auf demselben Niveau wie die Mittelebene der durchlässigen Schicht (108) des oberen Stapels (120s) befindet, der auf dem oberen Niveau der Unterlage niedergeschlagen ist, und wobei der untere Stapel (120i) einen Laser bildet, der in der Ebene der aktiven Schicht eine Strahlung emittiert, die in die durchlässige Schicht des oberen Stapels (120s), der als optischer Leiter dient, eindringt und durch diese Schicht geleitet wird,

– man beizt die oberen Schichten (114, 116) des oberen Stapels (120s) ab, um die beiden unteren und oberen Stapel (120i, 120s) auf ein Niveau zu bringen.

2. Verfahren gemäß dem Anspruch 1, dadurch gekennzeichnet, daß man vor dem Niederschlagen der ersten Sperrschicht (106) auf der Unterlage, wenn diese halbisolierend ist, eine leitende Kontaktschicht (104) niederschlägt.

3. Verfahren gemäß dem Anspruch 1, dadurch gekennzeichnet, daß man der zweiten Sperrschicht (110), die auf der durchlässigen Schicht (108) des oberen Stapels (120s) angeordnet ist, eine Struktur als eingeteiltes Beugungsgitter gibt.

4. Fugenlose, aus einem Stück bestehende, optische Vorrichtung von plattenartigem Aufbau, erhalten durch das Verfahren gemäß dem Anspruch 1, mit einem Halbleiter-Laser und einem optischen Wellenleiter, die auf einer Unterlage durch Stapeln von durch Epitaxie gebildeten Schichten aufgebracht sind, mit

– einer Unterlage (100), deren Profil wenigstens einen Höhenverlauf (102, h) zwischen sich unterscheidenden Höhenniveaus, nämlich einem unteren und einem oberen Niveau aufweist,
– mit mehreren auf dieser Unterlage befindlichen, aufeinanderfolgenden Schichten, nämlich einer ersten Grenzschicht (106), einer Leiterschicht (108) aus einem Material, das für die von dem Laser emittierte Strahlung durchlässig ist, einer zweiten Sperrschicht (110), einer aktiven Schicht (112), einer dritten Sperrschicht (114), einer Kontaktschicht (116),
– einem Brechungsindex des durchlässigen Materials (108), der höher als der Index der Schichten (106, 110) ist, zwischen denen das Material eingefügt ist,
– mit solchen Größen der Dicke der durchlässigen Schicht (108), der zweiten Sperrschicht (110) und der aktiven Schicht (112), daß der Abstand (d), durch den die Mittelebenen der aktiven Schicht (112) und der durchlässigen Schicht (108) voneinander getrennt sind, gleich der Höhe (h) des Verlaufes (102) der Unterlage (100) sind, wobei sich die Mittelebene der aktiven Schicht (112) des niedrigeren Stapels (120i), der auf dem tieferen Niveau Unterlage (100) niedergeschlagen ist, dann auf demselben Niveau wie die Mittelebene der durchlässigen Schicht (108) des oberen Stapels (120s) befindet, der auf dem oberen Niveau der Unterlage aufgebracht ist,
– einem von dem unteren Stapel (120i) gebildeten Laser, der in der Ebene der aktiven Schicht (112) eine Strahlung emittiert, die in die durchlässige Schicht (108) des oberen Stapels (120s) eindringt, der als optischer Leiter dient, und von der durchlässigen Schicht (108) geleitet wird,
– abgebeizten oberen Schichten (114, 116) des oberen Stapels (120s), derart daß die beiden unteren und oberen Stapel (120i und 120s) dabei dasselbe Niveau haben.

5. Vorrichtung gemäß dem Anspruch 4, dadurch gekennzeichnet, daß zwischen der ersten Grenzschicht (106) und der Unterlage (100) eine leitende Kontaktschicht (104) vorgesehen ist, wenn die Unterlage halbisolierend ist.

6. Vorrichtung gemäß dem Anspruch 4, dadurch gekennzeichnet, daß der untere Stapel (120i) durch zwei obere Stapel (120's, 120"s) vergrößert ist, und daß die durch die aktive Schicht (112) des unteren Stapels (120i) emittierte Strahlung in die durchlässigen Schichten (108) der beiden oberen Stapel (120's, 120"s) eindringt und von diesen Schichten (108) geleitet wird, wobei die zweite Grenzschicht (110), die auf der durchlässigen Schicht (108) der oberen Stapel (120's, 120"s) angeordnet ist, eine Struktur eines eingeteilten Beugungsgitters (125', 125") aufweist.

7. Vorrichtung gemäß dem Anspruch 4, dadurch gekennzeichnet, daß der den Laser bildende, untere Stapel (120i) von dem oberen Stapel (120s) durch eine eingravierte Rille (121) getrennt ist.

8. Vorrichtung gemäß dem Anspruch 7, dadurch gekennzeichnet, daß der obere Stapel (120s) so angetrieben wird, daß er eine elektro-optische Funktion, besonders die eines Photodetektors oder Modulators übernimmt.

**Claims**

1. Process for the production of a monolithic integrated optical device with a planar structure incorporating at least one semiconductor laser and an optical waveguide by stacking semiconductor layers by epitaxy on a substrate, comprising the following operations:

– the substrate (100) is given a profile having at least one step (102) of height (h) between two different height levels, namely a lower level and a higher level;
– on said substrate is deposited by a single vapour phase epitaxy operation and in a successive manner a first confinement layer (106), a guidance layer (108) made from a material transparent for the radiation emitted by the laser, a second confinement layer (110), an active layer (112), a third confinement layer (114) and a contact layer (116);
– the transparent material (108) is chosen in such a way that its refractive index is higher than the indices of the confinement layers (106, 110) surrounding it;
– thickness values are given to the transparent layer (108), the second confinement layer (110) and the active layer (112) such that the distance (d) separating the median planes of the active layer (112) and the transparent layer (108) is equal to the height (h) of the substrate step (102), the active layer of the lower stack (112) deposited on the lower stack (120i) of the substrate then being located at the same level as the transparent layer (108) of the upper stack (120s) deposited on the upper level of the substrate, the the plane of the active layer, said radiation penetrating into and being guided by the transparent layer of the upper stack (120s) serving as an optical guide;

— the upper layers (114, 116) of the upper stack (120s) are etched to bring level the lower and upper two stacks (120i, 120s).

2. Process according to claim 1, characterized in that before depositing the first confinement layer (106), a contact conducting layer (104) is deposited on the substrate, if it is a semi-insulating substrate.

3. Process according to claim 1, characterized in that a distributed diffraction grating structure is given to the second confinement layer (110) located on the transparent layer (108) of the upper stack (120s).

4. Monolithic integrated optical device with a planar structure obtained by the process according to claim 1, said device comprising a semiconductor laser and an optical waveguide formed from stacks of epitactic layers on a substrate, said device comprising

— a substrate (100) having a profile with at least one step (102) of height (h) between two different height levels, namely a lower level and an upper level;
— on said substrate are successively deposited a first confinement layer (106), a guidance layer (108) made from a material transparent to the radiation emitted by the laser, a second confinement layer (110), an active layer (112), a third confinement layer (114) and a contact layer (116);
— the transparent material (108) having a refractive index higher than the indices of the confinement layers (106, 110) surrounding it;
— the thicknesses of the transparent layer (108), the second confinement layer (110) and the active layer (112) having values such that the distance (d) separating the median planes of the active layer (112) and the transparent layer (108) is equal to the height (h) of the substrate (100) step (102), the median plane of the active layer (112) of the lower stack (120i) deposited on the lower level of the substrate (100) then being at the same level as the transparent layer (108) of the upper stack (120s) deposited on the upper level of the substrate;
— the lower stack (120i) of said device constituting a laser emitting radiation in the plane of the active layer (112), said radiation penetrating into and being guided by the transparent layer (108) of the upper stack (120s) serving as an optical guide;
— the upper layers (114, 116) of the upper stack (120s) are etched, so that the two lower (120i) and upper (120s) stacks are then at the same level.

5. Device according to claim 4, characterized in that it comprises, between the first confinement layer (106) and the substrate (100), a conducting contact layer (104) if it is a semi-insulating substrate.

6. Device according to claim 4, characterized in that it comprises a lower stack (120i) extended by two upper stacks (120's, 120"s), the radiation emitted by the active layer (112) of the lower stack (120i) penetrating into and being guided by the transparent layers (108) of the two upper stacks (120's, 120"s), the second confinement layer (110) located on the transparent layer (108) of the upper stacks (120's, 120"s) having a distributed diffraction grating structure (125', 125").

7. Device according to claim 4, characterized in that the lower stack (120i) constituting the laser is separated from the upper stack (120s) by an etched channel (121).

8. Device according to claim 7, characterized in that the upper stack (120s) is such that it fulfils an electrooptical function, particularly a photodetection or modulation.

FIG.1

FIG.2

FIG.3

FIG.4

FIG.5

FIG.6

# FIG.7